Europäisches Patentamt

European Patent Office

Office européen des brevets

(11) Veröffentlichungsnummer: **0 423 483 A2**

# (12) EUROPÄISCHE PATENTANMELDUNG

(21) Anmeldenummer: 90117538.0

(22) Anmeldetag: 12.09.90

(51) Int. Cl.5: **G01R 31/36**

(30) Priorität: 14.10.89 DE 3934353

(43) Veröffentlichungstag der Anmeldung:
24.04.91 Patentblatt 91/17

(84) Benannte Vertragsstaaten:
CH DE FR GB IT LI NL SE

(71) Anmelder: MERCEDES-BENZ AKTIENGESELLSCHAFT

Postfach 60 02 02
W-7000 Stuttgart 60(DE)

(72) Erfinder: **Benz, Klemens**
Hauptstrasse 204
W-6729 Belheim(DE)
Erfinder: **Kübler, Rainer**
Schönestrasse 27
W-7000 Stuttgart 50(DE)

(54) Verfahren zur Bestimmung des Zustandes eines Akkumulators.

(57) Die vorliegende Erfindung betrifft ein Verfahren zur Bestimmung des Zustandes eines Akkumulators, indem ausgehend von einem definierten Ladungszustand des Akkumulators in einem Zyklus ein Aufladungs- und ein Entladungsvorgang mit jeweils einem bestimmten Strom stattfindet, wobei der Zyklus beendet ist, wenn der definierte Ladungszustand wieder erreicht ist und wobei aus der Differenz der für den Aufladungs- und den Entladungsvorgang benötigten Zeiträume auf den Zustand des Akkumulators geschlossen wird. Alternativ kann von einem definierten Ladungszustand des Akkumulators eine Entladung durchgeführt werden, um aus der entnommenen Ladung die verfügbare Kapazität zu bestimmen.

*Fig. 1*

## VERFAHREN ZUR BESTIMMUNG DES ZUSTANDES EINES AKKUMULATORS

Die Erfindung betrifft ein Verfahren zur Bestimmung des Zustandes eines Akkumulators gemäß dem Oberbegriff der Patentansprüche 1, 2 und 3.

Es ist bereits eine Batterie-Wartungsvorrichtung bekannt (DE 32 05 390 A1), wonach eine Batterie gewartet wird, indem sie zunächst geladen wird, um dann mit einem vorzugsweise konstanten Strom auf einen vorzugebenden Minimalwert der Batteriespannung entladen und anschließend wieder bis zu dem Maximalwert geladen zu werden. Als Kriterium für den Zustand der zu wartenden Batterie wird dabei die während des Entladevorganges gemessene Batteriekapazität herangezogen. Diese gemessene Batteriekapazität wird mit der Nennkapazität verglichen, um eine Entscheidung zu treffen, ob die Batterie funktionsfähig ist oder nicht. Diese Entscheidung wird dem Benutzer der Batterie-Wartungsvorrichtung akustisch und/oder optisch angezeigt. Außerdem wird ein anderes Verfahren zur Bestimmung des Zustandes einer Batterie beschrieben, bei dem ausgehend von der maximal erreichbaren Klemmenspannung die Batterie bis zur Entladeschlußspannung entladen wird. Anschließend wird der Batterie eine Ladungsmenge zugeführt, die der gesamten Ampere-Stundenkapazität der Batterie entspricht. Der Zustand der Batterie wird dabei durch Messung geeigneter Parameter abgeleitet.

Bei diesem bisher bekannten Verfahren ergeben sich Nachteile dahin gehend, daß die Batterie nicht mit dem im Betrieb auftretenden Entladestrom geprüft und gewartet wird, wodurch eine Batterie noch als fehlerfrei akzeptiert wird, obwohl sie u.U. bei Belastung mit höheren Strömen schon nicht mehr als funktionsfähig erkannt wird.

Seitens der Firma General Electric Company (in Deutschland: seitens General Electric Plastics GmbH, Battery Department, D-609 Rüsselsheim, Eisenstr. 5) wurde unter der Publication Number GET-3148AD ein Buch mit dem Titel "Der Nickel-Cadmium Akkumulator - Anwendungstechnisches Handbuch" veröffentlicht, aus dessen zweiter Auflage es bekannt ist, daß die kapazität eines Akkumulators im Laufe seiner Lebensdauer abnimmt. Ebenso ist daraus bekannt, daß die Kapazität eines Akkurmulators mit steigender Entladerate abnimmt. In dieser Veröffentlichung sind über diese Grundlagen hinaus keine Angaben gemacht, wie diese Kenntnisse vorteilhaft bei der Überprüfung von Akkumulatoren eingesetzt werden können.

Weiterhin bekannt ist ein Verfahren zur Bestimmung des Zustandes eines Akkumulators (DE 31 08 844 A1), nach dem ein Akkumulator mit einem größen Entladestrom entladen wird. Gemessen wird dann die Klemmenspannung des Akkumulators in einem Zeitintervall unmittelbar nach dem Abschalten des Entladeströmes. Aus dem zeitlicvhen Verlauf der Klemmenspannung in der Regenerierungsphase des Akkumulators wird dann auf den Zustand des Akkumulators geschlossen.

Aufgabe der Erfindung ist es, einen Akkumulator unter Bedingungen zu testen, die den Einsatzbedingungen des Akkumulators entsprechen, um somit einen Akkumulator rechtzeitig als funktionsunfähig erkennen zu können und/oder einen Akkumulator zu testen, der nicht mehr so weit aufgeladen werden kann, daß er an seinen Klemmen die Ladeschlußspannung aufweist.

Diese Aufgabe wird bei einem gattungsgemäßen Verfahren zur Bestimmung des Zustandes eines Akkumulators erfindungsgemäß mit den kennzeichnenden Merkmalen des Anspruchs 1 gelöst, wobei die Merkmale der Unteransprüche vorteilhafte Aus- und Weiterbildungen kennzeichnen.

Weitere Vorteile der Erfindung gegenüber dem bekannten Stand der Technik bestehen darin, daß die Punkte der Kennlinie, die bestimmte Zustände des Akkumulators charakterisieren so gewählt werden können, daß sie in Gebieten liegen, in denen die Kennlinie einen recht steilen Verlauf aufweist, d.h., daß die Klemmenspannung wegend des steileren Verlaufes der Kennlinie in diesen Punkt relativ leicht einem Punkt der Kennlinie zugeordnet werden kann.

Bei der Durchführung des erfindungsgemäßen Verfahrens muß die dem Akkumulator zugeführte bzw. entnommene Ladung bestimmt werden. Dies geschieht durch eine Integration des Stromes über der Zeit. Diese Integration kann erfolgen, indem der Strom abgetastet gemessen wird, woraus sich aus den gemessenen Werten des Stromes und der Abtastfrequenz grundsätzlich die Werte ergeben, die für eine Approximation des Integrals durch eine der bekannten Summenformeln ergeben.

Bei dem mit Verfahrensablauf I bezeichneten Teil des erfindungsgemäßen Verfahrens ist es möglich, Akkumulatoren zu testen, die beim Aufladen die volle Ladeschlußspannung nicht mehr erreichen. Es ist zweckmäßig, den Lade- und den Entladestrom bei der Durchführung dieses Teils des erfindungsgemäßen Verfahrens in der Größenordnung des häufiger auftretenden maximalen Entladestromes des Akkumulators unter normalen Betriebsbedingungen einzustellen. Bei diesem Teil des erfindungsgemäßen Verfahrens wird bei einem Lade-/Entladezyklus des Akkumulators eine Bilanz von der dem Akkumulator zugeführten zu der dem Akkumulator entnommenen Ladungsmenge aufgestellt. Aus der Differenz dieser Ladungsmengen kann auf die in dem Akkumulator während eines solchen Zyklus verbrauchte Wärmeenergie geschlossen werden.

Bei dem mit Verfahrensablauf II bezeichneten Teil des erfindungsgemäßen Verfahrens wird ein Akkumulator in einem Zustand I, der dadurch gegeben ist, daß der Akkumulator voll geladen ist, d.h. daß an seinen Klemmen die momentane Spannung $U_{akt}$ gleich der Ladeschlußspannung ist, mit einem erheblich über seinem Nennstrom liegenden Entladestrom entladen bis er einen Zustand II erreicht hat, der dadurch gegeben ist, daß an den Klemmen des Akkumulators die momentane Spannung $U_{akt}$ gleich der Entladeschlußspannung $U_{SE}$ ist. Dadurch wird der sogenannte "dynamische Innenwiderstand" erfaßt, d.h. es wird beim Entladen mit dem größen Entladestrom der bei größen Entladeströmen deutlich größere Umsatz von elektrischer Energie in Wärmeenergie in dem Akkumulator berücksichtigt. Dadurch wird eine die Einsatzbedingungen des Akkumulators berücksichtigende Aussage über die Kapazität getroffen. Bei dem erfindungsgemäßen Verfahren kann dabei eine zweckmäßige Größenordnung für den Entladestrom in einem Bereich von ca. dem 50-fachen Nennstrom des Akkumulators liegen. Bei einer anderen Belastung des Akkumulators im Betriebszustand können für die Durchführung des erfindungsgemäßen Verfahrens auch andere Entladeströme zweckmäßig sein. In vorteilhafter Weise wird bei der Durchführung des erfindungsgemäßen Verfahrens der Entladestrom in der Größenordnung der unter normalen Betriebsbedingungen häufiger auftretenden maximalen Entladeströme eingestellt. Dabei wird in vorteilhafter Weise bei der Durchführung des erfindungsgemäßen Verfahrens berücksichtigt, daß sich ein Akkumulator nach einer starken Belastung regeneriert, d.h. daß seine Klemmenspannung wieder ansteigt, wenn kein Entladestrom mehr fließt. Dies kann berücksichtigt werden, indem nach einer Belastung des Akkumulators mit einem starken Strom nach einer Regenerationsphase $t_{delay}$ der Akkumulator erneut entladen wird bis er den Zustand II erreicht hat. Die in diesem Schritt ermittelte Restkapazität wird zu der kapazität addiert, die bei der Belastung des Akkumulators mit dem starken Strom ermittelt wurde.

Ein Ausführungsbeispiel der Erfindung ist in der Zeichnung schematisch dargestellt und wird im folgenden näher beschrieben. Es zeigen:

Fig. 1: ein Diagramm der Klemmenspannung eines Akkumulators über der Zeit bei einem konstanten Entladestrom,

Fig. 2: ein Flußdiagramm des Verfahrensablaufes I des erfindungsgemäßen Verfahrens und

Fig. 3: ein Flußdiagramm des Verfahrensablaufes II des erfindungsgemäßen Verfahrens.

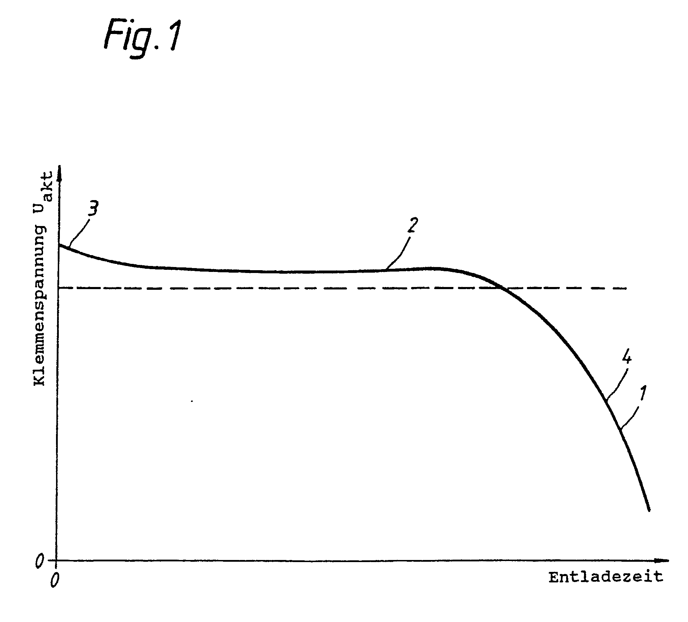

Das in Fig. 1 dargestellte Diagramm zeigt den Verlauf der Klemmspannung eines Akkumulators

über der Zeit bei einer Entladung mit einem konstanten Strom. Der Punkt 3 liegt auf dem Teil der Kurve, der den Zustand des voll geladenen Akkumulators repräsentiert und entspricht der Ladeschlußspannung, der Punkt 2 liegt auf dem Teil der Kurve, der die Klemmenspannung des Akkumulators in normalem Betriebszustand repräsentiert, und der Punkt 1 liegt auf dem Teil der Kurve, der den Entladungszustand des Akkumulators repräsentiert. In einer besonders vorteilhaften Weise kann der Punkt 1 der Kurve als die Klemmenspannung verwendet werden, die den "definierten Ladungszustand" des Akkumulators bei der Durchführung des erfindungsgemäßen Verfahrens repäsentiert. Da die Kurve an diesem Punkt 1 steil verläuft, ist dieser Punkt 1 relativ einfach anzufahren; für die Durchführung des erfindungsgemäßen Verfahrens kann jedoch auch ein anderer Punkt der Kurve verwendet werden.

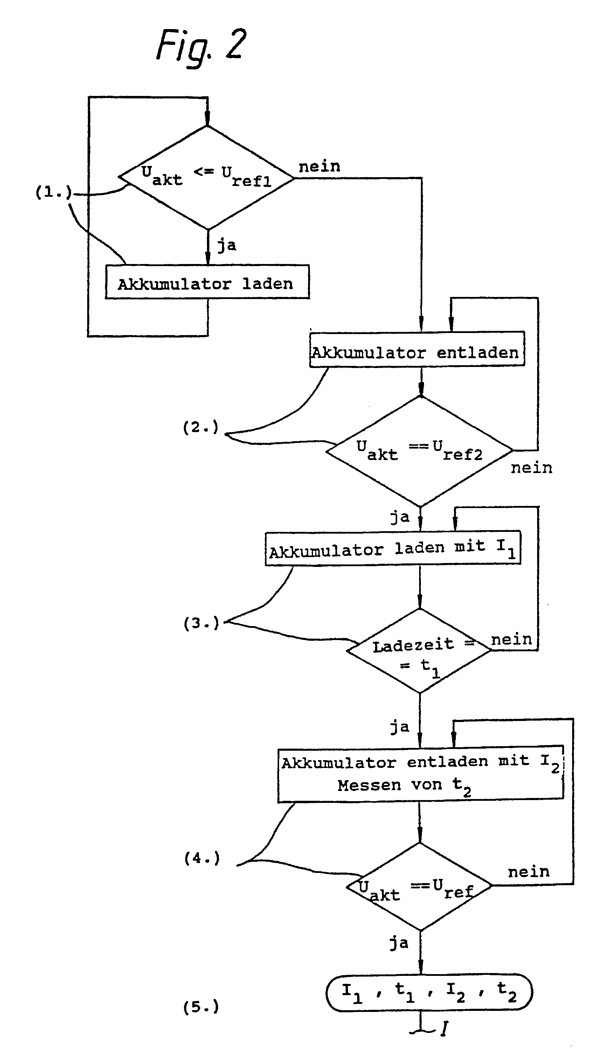

Wie aus dem in Fig. 2 abgebildeten Flußdiagramm ersichtlich, wird bei dem Verfahrensablauf I zunächst eine für die Durchführung des erfindungsgemäßen Verfahrens vorgesehene Lade-/Entladevorrichtung so angesteuert, daß der Akkumulator einen definierten Ladungszustand erreicht. Dieser definierte Ladungszustand entspricht einer bestimmten Klemmenspannung; beispielsweise kann der Ladungszustand bestimmt werden, indem die Klemmenspannung des Akkumulators gemessen wird. Die Klemmenspannung, die den definierten Ladungszustand kennzeichnet, wird mit $U_{ref2}$ bezeichnet. Besonders vorteilhaft kann dabei der Punkt 1 in der Fig. 1 verwendet werden, um einen Ladungszustand des Akkumulators zu definieren. Ohne Beschränkung der Allgemeinheit wird im folgenden die Durchführung des Verfahrensablaufes I beschrieben, wenn der Strom $I_1$ ein Ladestrom und der Strom $I_2$ ein Entladestrom ist. In einer einfachen Umkehr kann der Zyklus des Verfahrensablaufes I auch so gebildet werden, daß der Strom $I_1$ ein Entladestrom und der Strom $I_2$ ein Ladestrom ist. Dazu wird die Referenzspannung $U_{ref}$ dann vorzugsweise in einen der Teile der Kurve der Fig. 1 gelegt, die den Punkt 2 oder den Punkt 3 enthält. Außerdem wird in einer vorteilhaften Ausgestaltung des erfindungsgemäßen Verfahrens die Referenzspannung $U_{ref2}$ zu Beginn des Zyklus aus derselben Richtung angefahren wie zum Ende des Zyklus. D.h., daß zu Beginn eines Zyklus die Referenzspannung von oben angefahren wird, wenn der Zyklus mit einem Aufladungsvorgang beginnt und umgekehrt. Als besonders zweckmäßig hat es sich dabei erwiesen, vor dem Anfahren der Referenzspannung $U_{ref2}$ den Akkumulator so zu laden bzw. zu entladen, daß er an seinen Klemmen eine solche momentane Klemmspannung $U_{akt}$ aufweist, daß der Akkumulator mittels eines Stromes $I_{V1}$ auf einen Ladungszustand gebracht wird, der einer mo-

mentanen Klemmenspannung $U_{akt}$ entspricht, die gleich einer Referenzspannung $U_{ref1}$ ist und daß von dort die Referenzspannung $U_{ref2}$ durch einen Strom $I_{v2}$ angefahren wird, wobei die Ströme $I_{v1}$ und $I_{v2}$ dieselbe Richtung haben wie der Strom, der am Ende des Zyklus fließt und wobei die Referenzspannungen $U_{ref1}$ und $U_{ref2}$ einen deutlichen Abstand aufweisen. Eine Größenordnung für diesen deutlichen Abstand ergibt sich beispielsweise daraus, daß die Referenzspannung $U_{ref1}$ in etwa bei dem Punkt 2 der Kurve der Fig. 1 liegen sollte, wenn die Referenzspannung $U_{ref2}$ dem Punkt 1 der Kurve der Fig. 1 entspricht. Der Punkt 2 sollte dabei in etwa in der Mitte des Teiles der Kurve der Fig. 1 liegen, der die Klemmenspannung des Akkumulators im normalen Betriebszustand repräsentiert.

Wurde in dem Schritt (1.) festgestellt, daß die aktuelle Klemmenspannung $U_{akt}$ kleiner ist als die Referenzspannung $U_{ref1}$, wird die Lade-/Entladevorrichtung zunächst so angesteuert, daß der Akkumulator geladen wird bis die aktuelle Klemmenspannung des Akkumulators $U_{akt}$ oberhalb der Referenzspannung $U_{ref1}$ liegt. Anschließend wird in dem Schritt (2.) die Lade-/Entladevorrichtung so angesteuert, daß der Akkumulator entladen wird bis die aktuelle Klemmenspannung $U_{akt}$ gleich der Referenzspannung $U_{ref2}$ ist. Anschließend startet in dem Schritt (3.) ein Zyklus, indem ein definierter Strom $I_1$ fließt, der in dem beschriebenen Ausführungsbeispiel ein Ladestrom ist. Dieser Ladestrom fließt während einer bestimmten Zeit $t_1$. Ist diese Zeit $t_1$ abgelaufen, wird der Akkumulator in dem Schritt (4.) mit einem definierten Entladestrom $I_2$ entladen, bis die aktuelle Klemmenspannung $U_{akt}$ wieder gleich der Referenzspannung $U_{ref2}$ ist. Die Zeit $t_2$ während dieses Schrittes (4.) wird gemessen. Am Ende eines Zyklus wird der Zustand des Akkumulators ermittelt, indem in einem Schritt (5.) die gemessenen Daten einer Auswertungseinheit zugeführt werden, in der der Strom $I_1$ während des Ladungsvorganges multipliziert wird mit der Zeit $t_1$, um so die dem Akkumulator zugeführte Ladung $Q_+$ zu ermitteln und in der der Strom $I_2$ während des Entladungsvorganges multipliziert wird mit der Zeit $t_2$, um so die dem Akkumulator entnommene Ladung $Q_-$ zu ermitteln. Der Quotient $Q_{rel} = Q_-/Q_+$ liefert dann ein Mäß für den Zustand des Akkumulators, wobei ein kleiner Quotient auf einen schlechten Zustand des Akkumulators schließen läßt. Der Quotient $Q_{rel}$ stellt somit durch die Bilanz der dem Akkumulator zugeführten und der dem Akkumulator entnommenen Ladungsmenge ein indirektes Maß für die Größenordnung des Umsatzes von elektrischer Energie in Wärmeenergie dar. Die Ströme $I_1$ und $I_2$ können dabei in der Größenordnung von 1 A liegen, die Zeitdauer $t_1$ kann Werte in der Größenordnung von 15 min betragen. Ein geeigneter Grenzwert $Q_{relSW}$ für den Quotienten $Q_{rel}$ liegt bei ca. 75%, d.h., daß ein Akkumulator, der diesen Grenzwert unterschreitet, zweckmäßigerweise entsorgt wird. Es ist allerdings auch möglich, die Größenordnung der Ströme $I_1$ und $I_2$ den Einsatzbedingungen des Akkumulators anzupassen, d.h. daß Akkumulatoren, die im Betriebszustand mit großen Strömen belastet werden auch bei einem Test nach dem Verfahrensablauf I mit größeren Strömen belastet werden. Dadurch treten Verluste im Akkumulator bei dem Test entsprechend den Verlusten im Betriebszustand auf. Entsprechend ändert sich dann natürlich die Zeitdauer $t_1$, da bei dem in diesem Ausführungsbeispiel beschriebenen Verfahrensablauf I die maximale Klemmenspannung die Ladeschlußspannung nicht erreichen sollte.

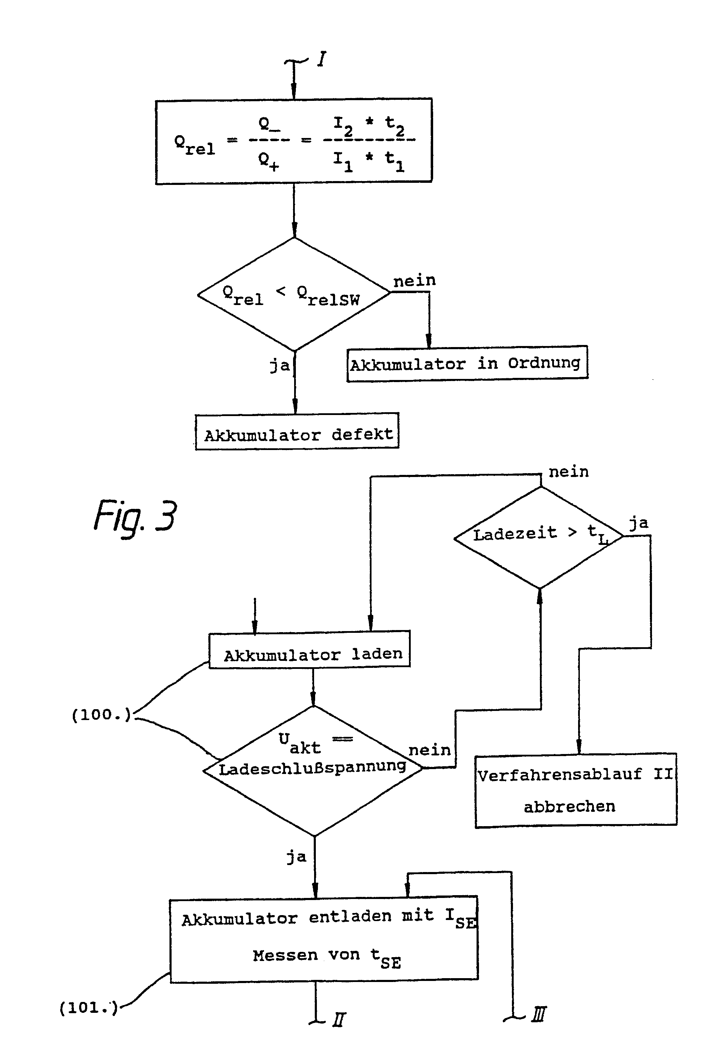

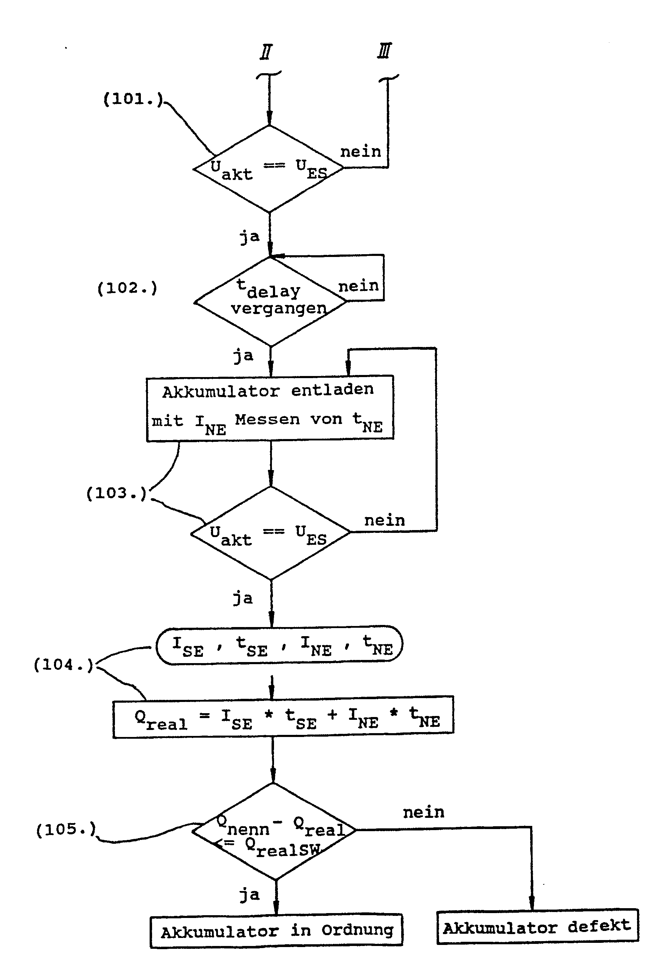

Entsprechend dem in Fig. 3 dargestellten Flußdiagramm des Verfahrensablaufes II wird der Akkumulator in dem Schritt (100.) zunächst geladen, bis seine Klemmenspannung $U_{akt}$ die Ladeschlußspannung erreicht, die durch den Punkt 3 der in Fig. 1 dargestellten Kurve charakterisiert ist. Dieser Ladungsvorgang geschieht mit einem Strom $I_L$ der in einer vorteilhaften Ausführungsform deutlich oberhalb des Nennstromes des Akkumulators liegt, d.h. daß der Strom $I_L$ ca. das 50-fache des Nennstromes betragen kann. Hat der Akkumulator nach einer vorgegebenen Zeit $t_L$ die Ladeschlußspannung noch nicht erreicht, wird der Verfahrensablauf II abgebrochen. Die Zeit $t_L$ kann dabei in der Größenordnung von ca. 1 Minute liegen. Nach Erreichen der Ladeschlußspannung wird der Akkumulator in dem Schritt (101.) mit einem Strom $I_{SE}$ entladen bis die Klemmenspannung $U_{akt}$ die Entladeschlußspannung $U_{ES}$ erreicht, die in Fig. 1 durch den Punkt 4 der Kurve charakterisiert ist, wobei dieser Punkt 4 mit dem Punkt 1 der Kurve zusammen fallen kann, der den "definierten Ladungszustand" bei dem Verfahrensablauf I charakterisiert. Dabei kann der Strom $I_{SE}$ deutlich oberhalb des Nennstromes des Akkumulators liegen, beispielsweise um einen Faktor 50 höher. Dadurch kann die im Betrieb eines Akkumulators vorkommende stoßartige Belastung simuliert werden. Es ist allerdings auch möglich, den Strom $I_{SE}$ in einer solchen Größenordnung zu wählen, die den häufiger auftretenden maximalen Strömen bei normalen Betriebsbedingungen entspricht. Die Zeitspanne $t_{SE}$, während der der Strom $I_{SE}$ fließt, wird gemessen. Um die nach einer Belastung mit einem großen Strom an dem Akkumulator auftretende Restkapazität durch die Regeneration zu erfassen, kann in einer besonders vorteilhaften Ausgestaltung des erfindungsgemäßen Verfahrens nach einer Zeitspanne $t_{delay}$, während der sich der Akkumulator regeneriert und die in dem Schritt (102.) abgewartet wird, der Akkumulator erneut entladen werden bis in dem Schritt (103.) die aktuelle

Klemmenspannung $U_{akt}$ erneut die Entladeschlußspannung $U_{ES}$ erreicht hat mit einem Strom $I_{NE}$, der vorzugsweise in der Größenordnung des Nennstromes liegt. Die Zeitdauer $t_{NE}$, während der der Strom $I_{NE}$ fließt, wird gemessen. Die gemessenen Daten werden dabei in dem Schritt (104.) der Auswertungseinheit zugeführt, in der die Kapazität $Q_{real}$ bestimmt wird, indem zu dem Produkt $I_{SE}*t_{SE}$ das Produkt $I_{NE}*t_{NE}$ addiert wird. Die Kapazität $Q_{real}$ wird in dem Schritt (105.) mit der Nennkapazität $Q_{nenn}$ verglichen und bei einer Differenz oberhalb eines vorzugebenden Schwellwertes $Q_{realSW}$, dessen Größenordnung so gewählt sein kann, daß dieser Schwellwert erreicht wird, wenn die Kapazität $Q_{real}$ gerade 75% der Nennkapazität $Q_{nenn}$ beträgt, wird der Akkumulator als nicht mehr funktionsfähig erkannt.

Die Lade-/Entladevorrichtung sowie die Auswertungseinheit können dabei Digitalrechner sein, wobei die Ströme in der entsprechenden Größe von dem Digitalrechner über einen D/A-Ausgang ausgegeben werden und die Zeiten mittels einer im Digitalrechner vorhandenen Echtzeituhr bestimmt werden können.

Das beschriebene Verfahren eignet sich in besonders vorteilhafter Weise für NiCd-Akkumulatoren, kann jedoch auch für andere Akkumulatoren verwendet werden. Dabei müssen dann die Größenordnung der vorzugebenden Ströme und Zeiten an die Parameter dieser Akkumulatoren angepaßt werden. Diese Parameter bestehen dabei im wesentlichen aus dem Sollwert der Klemmenspannung und der Nennkapazität der Akkumulatoren.

Zur Durchführung des Verfahrensablaufes II muß der Akkumulator an seinen Klemmen die Ladeschlußspannung aufweisen bzw. bis auf die Ladeschlußspannung aufladbar sein, wobei mit der Durchführung des Verfahrensablaufes I auch Akkumulatoren getestet werden können, welche die Ladeschlußspannung nicht mehr erreichen. Eine Einsatzmöglichkeit der beiden beschriebenen Verfahrensabläufe besteht beispielsweise darin, daß zunächst getestet wird, ob der Akkumulator an seinen Klemmen die Ladeschlußspannung erreichen kann. Ist dies der Fall, wird der Akkumulator mit der Durchführung des Verfahrensablaufes II getestet. Ist dies nicht der Fall, wird der Akkumulator mit der Durchführung des Verfahrensablaufes I getestet. Allerdings können mit der Durchführung des Verfahrensablaufes I auch Akkumulatoren getestet werden, die die Ladeschlußspannung erreichen, d.h. der Verfahrensablauf I kann auch unabhängig von dem Verfahrensablauf II erfolgen.

## Ansprüche

1. Verfahren zur Bestimmung des Zustandes eines Akkumulators
- wobei eine Kombination eines Entladungsvorganges des Akkumulators mit einem definierten Strom mit einem Aufladungsvorgang des Akkumulators mit einem definierten Strom erfolgt,
- wobei eine Lade-/Entladevorrichtung so angesteuert wird, daß der Akkumulator einen definierten Ladungszustand erreicht, der dadurch gegeben ist, daß die momentane Klemmenspannung $U_{akt}$ gleich einem vorzugebenden Referenzwert $R_{ref2}$ ist und
- wobei ein Signal erzeugt wird, wenn der Akkumulator den definierten Ladungszustand erreicht hat, in dem die momentane Klemmenspannung $U_{akt}$ gleich dem vorzugebenden Referenzwert $U_{ref2}$ ist,

**dadurch gekennzeichnet,**
- daß in einem dritten Schritt (3.) das Signal die Lade-/Entladevorrichtung so ansteuert, daß während eines definierten Zeitraumes $t_1$ ein bestimmter Strom $I_1$ fließt, dessen Richtung dem Entladungsvorgang entspricht,
- daß in einem vierten Schritt (4.) ein Signal erzeugt wird, das die Lade-/Entladevorrichtung so ansteuert, daß ein bestimmter Strom $I_2$, dessen Richtung dem Aufladungsvorgang entspricht, fließt bis sich der Akkumulator wieder in dem definierten Ladungszustand befindet und indem in diesem vierten Schritt (4.) der Zeitraum $t_2$ gemessen wird, während dem der definierte Strom $I_2$ fließt und
- indem in einem fünften Schritt (5.) die gemessenen Daten einer Auswertungseinheit zugeführt werden, in der aus einer Abweichung der Zeit $t_2$ von der Zeit $t_1$ auf die Größenordnung des Umsatzes von elektrischer Energie in Wärmeenergie geschlossen wird.

2. Verfahren zur Bestimmung des Zustandes eines Akkumulators
- wobei eine Kombination eines Entladungsvorganges des Akkumulators mit einem definierten Strom mit einem Aufladungsvorgang des Akkumulators mit einem definierten Strom erfolgt,
- wobei eine Lade-/Entladevorrichtung so angesteuert wird, daß der Akkumulator einen definierten Ladungszustand erreicht, der dadurch gegeben ist, daß die momentane Klemmenspannung $U_{akt}$ gleich einem vorzugebenden Referenzwert $U_{ref2}$ ist und
- wobei ein Signal erzeugt wird, wenn der Akkumulator den definierten Ladungszustand erreicht hat, in dem die momentane Klemmenspannung $U_{akt}$ gleich dem vorzugebenden Referenzwert $U_{ref2}$ ist,

**dadurch gekennzeichnet,**
- daß in einem dritten Schritt (3.) das Signal die Lade-/Entladevorrichtung so ansteuert, daß während eines definierten Zeitraumes $t_1$ ein bestimmter Strom $I_1$ fließt, dessen Richtung dem Aufladungsvorgang entspricht,
- daß in einem vierten Schritt (4.) ein Signal erzeugt wird, das die Lade-/Entladevorrichtung so ansteuert, daß ein bestimmter Strom $I_2$, dessen

Richtung dem Entladungsvorgang entspricht, fließt bis sich der Akkumulator wieder in dem definierten Ladungszustand befindet und indem in diesem vierten Schritt (4.) der Zeitraum $t_2$ gemessen wird, während dem der definierte Strom $I_2$ fließt und

- indem in einem fünften Schritt (5.) die gemessenen Daten einer Auswertungseinheit zugeführt werden, in der aus einer Abweichung der Zeit $t_2$ von der Zeit $t_1$ auf die Größenordnung des Umsatzes von elektrischer Energie in Wärmeenergie geschlossen wird.

3. Verfahren zur Bestimmung des Zustandes eines Akkumulators

- wobei ausgehend von einem Akkumulator in einem Zustand I, der dadurch gegeben ist, daß der Akkumulator an seinen Klemmen die Ladeschlußspannung aufweist, ein solches Signal generiert wird, das die Lade-/Entladevorrichtung so ansteuert, daß die Überführung des Akkumulators von dem Zustand I in einen Zustand II, der dadurch gegeben ist, daß der Akkumulator an seinen Klemmen die Entladeschlußspannung $U_{ES}$ aufweist, mit einem Entladestrom $I_{SE}$ erfolgt,

- wobei die Zeitspanne $t_{SE}$ gemessen wird, während der der Strom $I_{SE}$ fließt und

- wobei die gemessenen Daten einer Auswertungseinheit zugeführt werden, in der die Kapazität $Q_{real}$ des Akkumulators bestimmt wird, indem der Entladestrom $I_{SE}$ mit der Zeitspanne $t_{SE}$ multipliziert wird und in der aus einer Abweichung der bestimmten Kapazität $Q_{real}$ von der Nennkapazität $Q_{nenn}$ des Akkumulators auf den Zustand des Akkumulators geschlossen wird,

**dadurch gekennzeichnet,**

- daß der Entladestrom $I_{SE}$ deutlich über dem Nennstrom $I_{nenn}$ des Akkumulators liegt,

- daß nach der Überführung des Akkumulators in den Zustand II durch den während der Zeitspanne $t_{SE}$ fließenden Entladestrom $I_{SE}$ während einer Zeitspanne $t_{delay}$ die Lade-/Entladevorrichtung so angesteuert wird, daß weder ein Lade- noch ein Entladestrom fließt und

- daß die Lade-/Entladevorrichtung nach dieser Zeitspanne $t_{delay}$ so angesteuert wird, daß ein Entladestrom $I_{NE}$ fließt bis sich der Akkumulator erneut in dem Zustand II befindet,

- wobei die Zeitspanne $t_{NE}$ gemessen wird, während der der Strom $I_{NE}$ fließt und

- wobei die gemessenen Daten der Auswertungseinheit zugeführt werden, in der die Kapazität $Q_{real}$ berechnet wird, indem zu dem Produkt $I_{SE}*t_{SE}$ das Produkt $I_{NE}*t_{NE}$ addiert wird.

4. Verfahren nach Anspruch 1 oder 2,

**dadurch gekennzeichnet,**

daß die Ströme $I_1$ und $I_2$ den gleichen Betrag aufweisen.

5. Verfahren nach einem der Ansprüche 1, 2 oder 4,

**dadurch gekennzeichnet,**

daß die Ströme $I_1$ und $I_2$ in einer solchen Größenordnung liegen, die den häufiger auftretenden maximalen Strömen bei den üblichen Betriebsbedingungen des Akkumulators entspricht.

6. Verfahren nach einem der Ansprüche 1, 2, 4 oder 5,

**dadurch gekennzeichnet,**

daß der Zeitraum $t_1$ in der Größenordnung von 15 min liegt.

7. Verfahren nach einem der Ansprüche 1, 2 oder 4 bis 6,

**dadurch gekennzeichnet,**

daß der definierte Ladungszustand des Akkumulators bei Beginn eines Zyklus durch einen Strom in einer solchen Richtung angefahren wird, daß diese Richtung des Stromes identisch ist zur Richtung des Stromes $I_2$, der in dem vierten Schritt fließt.

8. Verfahren nach Anspruch 7,

**dadurch gekennzeichnet,**

daß der Akkumulator zunächst so geladen bzw. entladen wird, daß seine momentane Klemmenspannung $U_{akt}$ einen solchen Wert aufweist, daß von diesem Ladungszustand ausgehend die aktuelle Klemmenspannung $U_{akt}$ des Akkumulators durch einen Strom $I_{V1}$ auf einen solchen Wert gebracht wird, der gleich einer Referenzspannung $U_{ref1}$ ist, und daß die aktuelle Klemmenspannung $U_{akt}$ des Akkumulators von diesem Ladungszustand ausgehend durch einen Strom $I_{V2}$ bei Beginn des Zyklus auf einen solchen Wert gebracht wird, der gleich der Referenzspannung $U_{ref2}$ ist, wobei die Ströme $I_{V1}$ und $I_{V2}$ jeweils dieselbe Richtung aufweisen wie der Strom $I_2$, der in dem vierten Schritt fließt und wobei die Referenzspannung $U_{ref1}$ einen deutlichen Abstand von der Referenzspannung $U_{ref2}$ aufweist.

9. Verfahren nach Anspruch 8,

**dadurch gekennzeichnet,**

daß die Ströme $I_{V1}$ und $I_{V2}$ in der Größenordnung des Nennstromes des Akkumulators liegen.

10. Verfahren nach einem der Ansprüche 1, 2 oder 4 bis 9,

**dadurch gekennzeichnet,**

daß eine den Zustand des Akkumulators darstellende relative Kapazität $Q_{rel}$ bestimmt wird, indem der während des Entladungsvorganges fließende Strom $I_1$ bzw. $I_2$ mit der zugehörigen Zeit $t_1$ bzw. $t_2$ multipliziert wird und indem die sich so ergebende dem Akkumulator entnommene Ladung Q– durch die dem Akkumulator zugeführte Ladung Q+ dividiert wird, die sich ergibt, indem der während des Aufladungsvorganges fließende Strom $I_2$ bzw. $I_1$ mit der zugehörigen Zeit $t_2$ bzw. multipliziert wird und daß eine kleine relative Kapazität $Q_{rel}$ einem schlechten Zustand des Akkumulators entspricht.

11. Verfahren nach Anspruch 10,

**dadurch gekennzeichnet,**

daß für die relative Kapazität $Q_{rel}$ ein Schwellwert

$Q_{relSW}$ definiert wird, wobei der Akkumulator als nicht mehr funktionsfähig erkannt wird, wenn seine relative Kapazität $Q_{rel}$ unter den Schwellwert $Q_{relSW}$ sinkt.

12. Verfahren nach Anspruch 3,

**dadurch gekennzeichnet,**

daß der Entladestrom $I_{SE}$ in einer solchen Größenordnung liegt, die den häufiger auftretenden maximalen Strömen bei den üblichen Betriebsbedingungen des Akkumulators entspricht.

13. Verfahren nach Anspruch 3 oder 12,

**dadurch gekennzeichnet,**

daß die berechnete Kapazität $Q_{real}$ verglichen wird mit der Nennkapazität $Q_{nenn}$, wobei bei einer Abweichung der Kapazität $Q_{real}$ von der Nennkapazität $Q_{nenn}$ oberhalb eines Schwellwertes der Akkumulator als nicht mehr funktionsfähig erkannt wird.

14. Verfahren nach einem der Ansprüche 3, 12 oder 13,

**dadurch gekennzeichnet,**

daß, wenn der Akkumulator eine momentane Klemmenspannung $U_{akt}$ unterhalb der Ladeschlußspannung aufweist, der Akkumulator zu Beginn des Verfahrensablaufes II zunächst mit einem Strom $I_L$ geladen wird bis die momentane Klemmenspannung $U_{akt}$ gleich der Ladeschlußspannung ist, wobei der Verfahrensablauf II abgebrochen wird, wenn der Strom $I_L$ länger als eine vorgegebene Zeit $t_L$ fließt.

15. Verfahren nach Anspruch 14,

**dadurch gekennzeichnet,**

daß der Strom $I_L$ deutlich oberhalb des Nennstromes des Akkumulators liegt.

16. Verfahren nach Anspruch 13 oder 14,

**dadurch gekennzeichnet,**

daß die Zeit $t_L$ in der Größenordnung von einer Minute liegt.

# Fig. 1

# Fig. 2

(1.)

$U_{akt} \mathrel{<=} U_{ref1}$ — nein

ja

Akkumulator laden

Akkumulator entladen

(2.)

$U_{akt} == U_{ref2}$ — nein

ja

Akkumulator laden mit $I_1$

(3.)

Ladezeit = $t_1$ — nein

ja

Akkumulator entladen mit $I_2$
Messen von $t_2$

(4.)

$U_{akt} == U_{ref}$ — nein

ja

$I_1$ , $t_1$ , $I_2$ , $t_2$

(5.)

$I$

~ I

$$Q_{rel} = \frac{Q_-}{Q_+} = \frac{I_2 * t_2}{I_1 * t_1}$$

$Q_{rel} < Q_{relSW}$ — nein → Akkumulator in Ordnung

ja

Akkumulator defekt

## Fig. 3

nein

Ladezeit > $t_L$ — ja

Akkumulator laden

(100.)

$U_{akt} =$ Ladeschlußspannung — nein → Verfahrensablauf II abbrechen

ja

Akkumulator entladen mit $I_{SE}$

Messen von $t_{SE}$

(101.)

II                III

II   III

(101.)

$U_{akt} == U_{ES}$   nein

ja

(102.)   $t_{delay}$ vergangen   nein

ja

Akkumulator entladen

mit $I_{NE}$ Messen von $t_{NE}$

(103.)

$U_{akt} == U_{ES}$   nein

ja

(104.)   $I_{SE} , t_{SE} , I_{NE} , t_{NE}$

$Q_{real} = I_{SE} * t_{SE} + I_{NE} * t_{NE}$

(105.)   $Q_{nenn} - Q_{real} \leq Q_{realSW}$   nein

ja

Akkumulator in Ordnung   Akkumulator defekt

11